# EUROPEAN PATENT APPLICATION

(11) **EP 3 627 488 A1**
(43) Date of publication of application: **25.03.2020**
(21) Application number: 17910404.7
(22) Date of filing: 13.06.2017
(51) Int. Cl.: G09G 3/36

(54) **GOA CIRCUIT, AND LIQUID CRYSTAL DISPLAY**

(30) Priority: 16.05.2017 CN 201710343561
(71) Applicant: Shenzhen China Star Optoelectronics Semiconductor Display Technology Co., Ltd., Shenzhen, Guangdong 518132 (CN)
(72) Inventor: SHI, Longqiang, Shenzhen Guangdong 518132 (CN)
(74) Representative: Patentanwälte Olbricht Buchhold Keulertz
(86) International application number: PCT/CN2017/088020
(87) International publication number: WO 2018/209743

(57) **Abstract**

A GOA circuit, and liquid crystal display. The GOA circuit comprises: a pull-up control circuit (11) having a control end receiving a first control signal (XCK), a first connection end receiving a stage transfer signal (ST(N-n)), and a second connection end outputting a second control signal (Q(N)); and a pull-up circuit (12) comprising a first switch transistor (T1) having a control end coupled to the second connection end of the pull-up control circuit (11), a first connection end receiving a clock signal (CK), and a second connection end outputting a drive signal (G(N)), wherein when the first control signal (XCK) has a first voltage level, the pull-up control circuit (11) is disconnected, and the second control signal (Q(N)) is outputted to turn on the first switch transistor (T1) of the pull-up circuit (12); after a falling edge of the clock signal (CK), a duration during which the first control signal (XCK) has the first voltage level is greater than a predetermined period. A gate signal is fully pulled down to a low voltage level by means of delaying a low voltage level of the clock signal (CK), thus effectively preventing problems caused by a slow voltage decrease of Gate, such as unintended charging.

## Description

### BACKGROUND OF THE INVENTION

### 1. Field of the Invention

The present invention relates to a liquid crystal display technology, and more particularly to a GOA circuit and a liquid crystal display device.

### 2. Description of Related Art

GOA (Gate Driver on Array) technology is beneficial to a narrow-frame or a no-frame display product. Besides, the GOA technology can also reduce the bonding process of an external integral circuit so as to increase the capacity and decrease the product cost. As a result, the GOA technology has been widely applied and researched.

IGZO (indium gallium zinc oxide) has high mobility and good device stability, and when manufacturing the GOA circuit, a complexity of the GOA circuit can be decreased. Specifically, because of the high mobility, when using IGZO to manufacture the thin-film transistor in the GOA circuit, the size of the thin-film transistor using IGZO is smaller than a thin-film transistor manufacturing by a-Si (amorphous silicon) so as to be beneficial to a narrow-frame display device. At the same time, because of the good device stability, the number of the thin-film transistor and the power source for stabilizing the performance of the thin-film transistor can be reduced so as to manufacture a relative simple GOA circuit and decrease the power consumption.

However, the RC (resistor and capacitor) delay of the gate line will directly affect an output waveform of the GOA circuit. A picture quality of a high resolution display device is clearer, which can satisfy the demand for visual enjoyment. However, the RC delay of the gate line of a high resolution display device is larger so that the affection to the waveform of the GOA circuit is larger.

### SUMMARY OF THE INVENTION

The main technology problem solved by the present invention is to provide a GOA circuit and a liquid crystal display device, through delaying a time that the CK signal is at a low level such that the gate signal can be completely pulled down to a low level so that a wrong charging generated by slow falling time of Gate is prevented.

In order to solve the above technology problem, a technology solution adopted by the present invention is: providing a GOA circuit including multiple cascade shift register units, and each shift register unit comprises: a pull-up control circuit, a control terminal of the pull-up control circuit receives a first control signal, a first connection terminal of the pull-up control circuit receives a stage transfer signal, and a second connection terminal outputs a second control signal of the pull-up control circuit outputs a second control signal; a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal; a bootstrap capacitor coupled between the second connection terminal of the pull-up control circuit and the second connection terminal of the first switching tube; a transfer circuit including a second switching tube, wherein a control terminal of the second switching tube is coupled to the second connection terminal of the pull-up control circuit, a first connection terminal of the second switching tube receives the clock signal, and a second connection terminal of the second switching tube outputs a stage transfer signal; wherein, when the first control signal is at a first level, the pull-up control circuit is turned on and outputs the second control signal such that the first switching tube of the pull-up circuit is turned on; and wherein, after a falling edge of the clock signal, in one period of the first control signal, a time interval that the first control signal is at the first level is greater than 50%.

In order to solve the above technology problem, a technology solution adopted by the present invention is: providing a GOA circuit including multiple cascade shift register units, and each shift register unit comprises: a pull-up control circuit, a control terminal of the pull-up control circuit receives a first control signal, a first connection terminal of the pull-up control circuit receives a stage transfer signal, and a second connection terminal outputs a second control signal of the pull-up control circuit outputs a second control signal; a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal; a bootstrap capacitor coupled between the second connection terminal of the pull-up control circuit and the second connection terminal of the first switching tube; wherein, when the first control signal is at a first level, the pull-up control circuit is turned on and outputs the second control signal such that the first switching tube of the pull-up circuit is turned on; and wherein, after a falling edge of the clock signal, the first control signal is at the first level by a time interval that is greater than a preset value.

In order to solve the above technology problem, another technology solution adopted by the present invention is: providing a liquid crystal display device including a GOA circuit, wherein the GOA circuit includes multiple cascade shift register units, and each shift register unit comprises: a pull-up control circuit, a control terminal of the pull-up control circuit receives a first control signal, a first connection terminal of the pull-up control circuit receives a stage transfer signal, and a second connection terminal outputs a second control signal of the pull-up control circuit outputs a second control signal; a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal; a bootstrap capacitor coupled between the second connection terminal of the pull-up control circuit and the second connection terminal of the first switching tube; wherein, when the first control signal is at a first level, the pull-up control circuit is turned on and outputs the second control signal such that the first switching tube of the pull-up circuit is turned on; and wherein, after a falling edge of the clock signal, the first control signal is at the first level by a time interval that is greater than a preset value.

The beneficial effect of the present invention is: comparing to the conventional art, the GOA circuit of the present invention includes multiple cascade shift register units, and each shift register unit comprises: a pull-up control circuit, a control terminal of the pull-up control circuit receives a first control signal, a first connection terminal of the pull-up control circuit receives a stage transfer signal, and a second connection terminal outputs a second control signal of the pull-up control circuit outputs a second control signal; a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal; a bootstrap capacitor coupled between the second connection terminal of the pull-up control circuit and the second connection terminal of the first switching tube; wherein, when the first control signal is at a first level, the pull-up control circuit is turned on and outputs the second control signal such that the first switching tube of the pull-up circuit is turned on; and wherein, after a falling edge of the clock signal, the first control signal is at the first level by a time interval that is greater than a preset value.

### BRIEF DESCRIPTION OF THE DRAWINGS

FIG. 1 is a schematic structure diagram of a GOA circuit according to an embodiment of the present invention;
FIG. 2 is a schematic circuit diagram of a GOA circuit according to an embodiment of the present invention;
FIG. 3 is a schematic timing diagram of CK signal in the conventional art;
FIG. 4 is a schematic timing diagram of CK signal of a GOA circuit according to an embodiment of the present invention; and
FIG. 5 is a schematic structure diagram of a liquid crystal display device according to an embodiment of the present invention.

### DETAILED DESCRIPTION OF THE PREFERRED EMBODIMENT

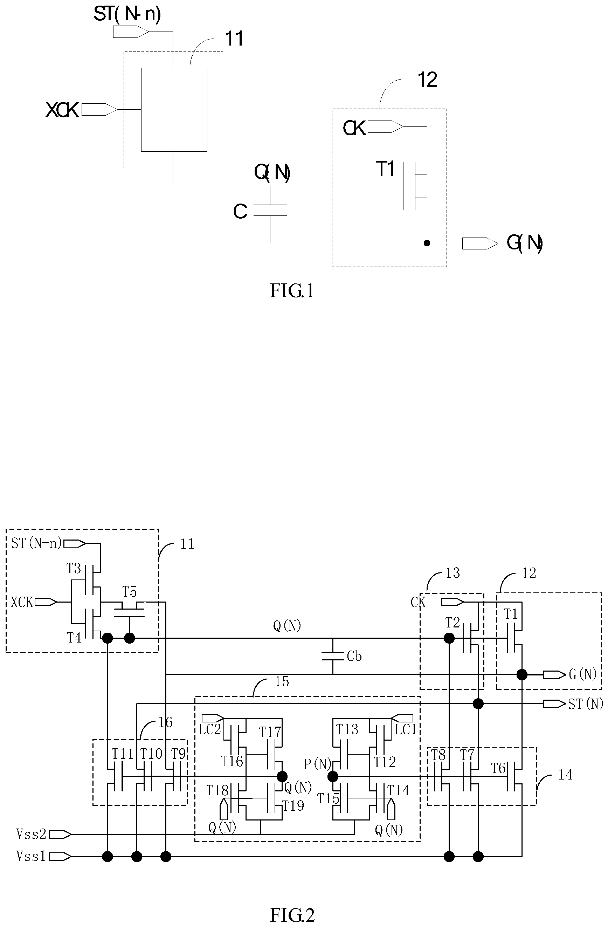

With reference to FIG. 1, and FIG. 1 is a schematic structure diagram of a GOA circuit according to an embodiment of the present invention. The GOA circuit includes cascade shift register unit, and the shift register unit includes:
A pull-up control circuit 11, a control terminal of the pull-up control circuit 11 receives a first control signal XCK, a first connection terminal of the pull-up control circuit 11 receives a stage transfer signal ST(N-n), and a second connection terminal of the pull-up control circuit 11 outputs a second control signal Q(N).

Wherein, the stage transfer signal can be a scanning signal (a stage transfer signal) outputted by previous n stage GOA circuit. The following will provide a specific embodiment, no more repeating here.

A pull-up circuit 12 includes a first switching tube T1, and a control terminal of the first switching tube T1 is coupled to the second connection terminal (that is, inputting the second control signal Q(N)) of the pull-up control circuit, a first connection terminal of the first switching tube T1 receives a clock signal CK, and a second connection terminal of the first switching tube T1 outputs a driving signal G(N).

A bootstrap capacitor C coupled between the second connection terminal of the pull-up control circuit (that is, the control terminal of T1) and the second connection terminal of the first switching tube T1 (that is, G(N)).

Wherein, the function of the bootstrap capacitor is that when G(N) is at a high level, maintaining Q(N) at a high level through a bootstrap function of the capacitor C.

It can be understood that in an actual application, the GOA circuit can also include a pull-down circuit, a pull-down holding circuit, etc. Here, circuit structures of other component circuits are not limited.

The following content will provide a specific circuit by an embodiment, as shown in FIG. 2.

The GOA circuit further includes:
a transfer circuit 13 including a second switching tube T2, and a control terminal of the second switching tube T2 is coupled to the second connection terminal of the pull-up control circuit 11 (that is, G(N)), a first connection terminal of the second switching tube T2 receives the clock signal CK, and a second connection terminal of the second switching tube T2 outputs a stage transfer signal ST(N). Wherein, the stage transfer output terminal ST(N) is similar to the scanning output terminal G(N), and is also outputting a CK signal when the T2 is turned on. However, the signal ST(N) is used for an input of a pull-up control circuit of a next stage or next n stage GOA circuit; and
a pull-up control circuit 11, including a third switching tube T3, and a fourth switching tube T4, wherein, a first connection terminal of the fourth switching tube T4 is coupled to a second connection terminal of the third switching tube T3, a second connection terminal of the fourth switching tube T4 is coupled to the control terminal of the first switching tube T1; and a fifth switching tube T5, a control terminal of the fifth switching tube T5 is coupled to the control terminal of the first switching tube T1, a first connection terminal of the fifth switching tube T5 is coupled to the first connection terminal of the fourth switching tube T4, a second connection terminal of the fifth switching tube T5 is coupled to the scanning output terminal G(N) for controlling a level at the control terminal of the third switching tube T3 to be less than a level at the first connection terminal of the third switching tube T3 when the scanning output terminal output a second level. wherein, a first connection terminal of the third switching tube T3 is inputted with a stage transfer signal ST(N-n) outputted by a previous stage (or previous n stage) GOA circuit. Each of a control terminal of the third switching tube T3 and the fourth switching tube T4 is inputted with the first control signal XCK.

It can be understood that in a scanning preparation stage (a stage before the scanning stage) of the GOA circuit, XCK is at a high level, a stage transfer signal ST(N-n) outputted by the previous stage GOA circuit is at a high level, CK is at a low level.

Specifically, under the high level of XCK, T3 and T4 are conductive, the signal ST(N-n) having the high level pulls up the second control signal Q(N). Under the high level of Q(N), T1 is turned on. However, CK is at a low level at this time so that G(N) outputs a low level.

In the scanning stage, XCK is at a low level, and CK is at a high level.

Specifically, under the low level of XCK, T3 and T4 are turned off, and Q(N) is held at a high level. Under the high level of Q(N), T1 continues to be turned on. At this time, CK is at a high level so that G(N) outputs a high level.

It should be noted that in this stage, under the high level of Q(N), T5 is turned on, the high level of G(N) is inputted into the first connection terminal of T4 such that a level at the first connection terminal of T4 is greater than a level at the control terminal of T4 in order to avoid a threshold drift of T4 in this stage and avoid turning on T4.

Besides, the GOA circuit further includes a first pull-down circuit 14, a clamp circuit 15 and a second pull-sown circuit 16, wherein, the first pull-down circuit 14 includes:
a sixth switching tube T6, wherein a first connection terminal of the sixth switching tube T6 is coupled to the scanning output terminal G(N);
a seventh switching tube T7, wherein a first connection terminal of the seventh switching tube T7 is coupled to the stage transfer terminal ST(N); and
an eighth switching tube T8, wherein a first connection terminal of the eighth switching tube T8 is coupled to the second output terminal of the third switching tube T3.

The clamp circuit 15 is coupled to control terminals and second connection terminals of the sixth switching tube T6, the seventh switching tube T7 and the eighth switching tube T8 for controlling a level of the control terminal of each of the sixth switching tube T6, the seventh switching tube T7 and the eighth switching tube T8 to be less than a level of the second connection terminal of each of the sixth switching tube T6, the seventh switching tube T7 and the eighth switching tube T8 when the scanning output terminal G(N) outputs a second level. Besides, when the scanning output terminal outputs a first level, the clamp circuit 15 controls the level of the control terminal of each of the sixth switching tube T6, the seventh switching tube T7 and the eighth switching tube T8 to be higher than the level of the second connection terminal of each of the sixth switching tube T6, the seventh switching tube T7 and the eighth switching tube T8. The second level is higher than the first level.

It can be understood that, when G(N) outputs a high level, T1 and T5 are turned on, Q(N) is at a high level. At this time, completely turning off T6, T7 and T8 should be ensured. In order to prevent the threshold drift of T6, T7 and T8 when being turned on, the clamp circuit 15 inputs Vss2 to the control terminal of each T6, T7 and T8, and inputs Vss1 to the second connection terminal of each T6, T7 and T8. Wherein, Vss1>Vss2, ensuring that completely turning off T6, T7 and T8.

When G(N) outputs a low level, turning on T6, T7 and T8 is required to pull down the level of G(N) through the low level of Vss1. Therefore, the clamp circuit 15 inputs a high level to the control terminal of each T6, T7 and T8, and inputs Vss1 to the second connection terminal of T6, T7 and T8 in order to ensure the conduction of T6, T7 and T8.

Wherein, the second pull-down circuit 16 includes:
a ninth switching tube T9, and a first connection terminal of the ninth switching tube T9 is coupled to the second connection terminal of the third switching tube T3;
a tenth switching tube T10, and a first connection terminal of the tenth switching tube T10 is coupled to the stage transfer output terminal ST(N); and
an eleventh switching tube T11, and a first connection terminal of the eleventh switching tube T11 is coupled to the scanning output terminal G(N).

The clamp circuit 15 is coupled to the control terminal and the second connection terminal of each of the ninth switching tube T9, the tenth switching tube T10 and the eleventh switching tube T11 for controlling the level of the control terminal of each of the ninth switching tube T9, the tenth switching tube T10 and the eleventh switching tube T11 to be lower than the level of the second connection terminal of each of the ninth switching tube T9, the tenth switching tube T10 and the eleventh switching tube T11 when the scanning output terminal G(N) outputs the second level. Besides, when the scanning output terminal outputs the second level, the clamp circuit 15 controls the level of the control terminal of each of the ninth switching tube T9, the tenth switching tube T10 and the eleventh switching tube T11 to be higher than the level of the second connection terminal of each of the ninth switching tube T9, the tenth switching tube T10 and the eleventh switching tube T11.

It can be understood that the operation principle of the second pull-down circuit 16 of the present embodiment is the same as the first pull-down circuit 14, no more repeating here.

It can be selected that in the present embodiment, the clamp circuit 15 controls the first pull-down circuit 14 and the second pull-down circuit to operate alternately.

Specifically, the clamp circuit 15 includes a first control circuit, a second control circuit, a first clamp terminal, and a second clamp terminal.

The first clamp terminal is inputted with a third level Vss1, coupled to the second connection terminals of the sixth switching tube T6, the seventh switching tube T7 and the eighth switching tube T8. The second clamp terminal is inputted with a fourth level Vss2, wherein, the third level Vss1 is higher than the fourth level Vss2.

The first control circuit includes:
a twelfth switching tube T12, wherein a control terminal and a first connection terminal of the twelfth switching tube T12 is inputted with a first control signal LC1;
a thirteenth switching tube T13, wherein a control terminal of the thirteenth switching tube T13 is coupled to a second connection terminal of the twelfth switching tube T12, a first connection terminal of the thirteenth switching tube T13 is inputted with the first control signal LC1, and a second connection terminal of the thirteenth switching tube T13 is coupled to the control terminals of the sixth switching tube T6, the seventh switching tube T7 and the eighth switching tube T8;
a fourteenth switching tube T14, wherein a control terminal of the fourteenth switching tube T14 is coupled to the second connection terminal of the third switching tube T3, a first connection terminal of the fourteenth switching tube T14 is coupled to the second connection terminal of the twelfth switching tube T12, and a second connection terminal of the fourteenth switching tube T14 is coupled to the second clamp terminal; and
a fifteenth switching tube T15, wherein a control terminal of the fifteenth switching tube T15 is coupled to the second connection terminal of the third switching tube T3, a first connection terminal of the fifteenth switching tube T15 is coupled to the second connection terminal of the thirteenth switching tube T13, and a second connection terminal of the fifteenth switching tube T15 is coupled to the second clamp terminal;
wherein, defining a level of the control terminal of each of the sixth switching tube T6, the seventh switching tube T7 and the eighth switching tube T8 is P(N).

The second control circuit includes:
a sixteenth switching tube T16, and a control terminal and a first connection terminal of the sixteenth switching tube T16 is inputted with a second control signal LC2;
a seventeenth switching tube T17, wherein a control terminal of the seventeenth switching tube T17 is coupled to a second connection terminal of the sixteenth switching tube T16, a first connection terminal of the seventeenth switching tube T17 is inputted with the second control signal LC2, and a second connection terminal of the seventeenth switching tube T17 is coupled to the control terminals of the ninth switching tube T9, the tenth switching tube T10 and the eleventh switching tube T11;
an eighteenth switching tube T18, wherein a control terminal of the eighteenth switching tube T18 is coupled to the second connection terminal of the third switching tube T3, a first connection terminal of the eighteenth switching tube T18 is coupled to the second connection terminal of the sixth switching tube T16, and a second connection terminal of the eighteenth switching tube T18 is coupled to the second clamp terminal; and
a nineteenth switching tube T19, wherein a control terminal of the nineteenth switching tube T19 is coupled to the second connection terminal of the third switching tube T3, a first connection terminal of the nineteenth switching tube T19 is coupled to the second connection terminal of the seventh switching tube T17, and a second connection terminal of the nineteenth switching tube T19 is coupled to the second clamp terminal;
wherein, defining a level of the control terminal of each of the ninth switching tube T9, the tenth switching tube T10 and the eleventh switching tube T11 is K(N).

Optionally, the pull-up circuit 11 further includes a capacitor Cb coupled between the scanning output terminal G(N) and the control terminal of the first switching tube T1.

The following content will compare and analysis the conventional technology and the present embodiment using a specific circuit described above and eight groups of CK signal.

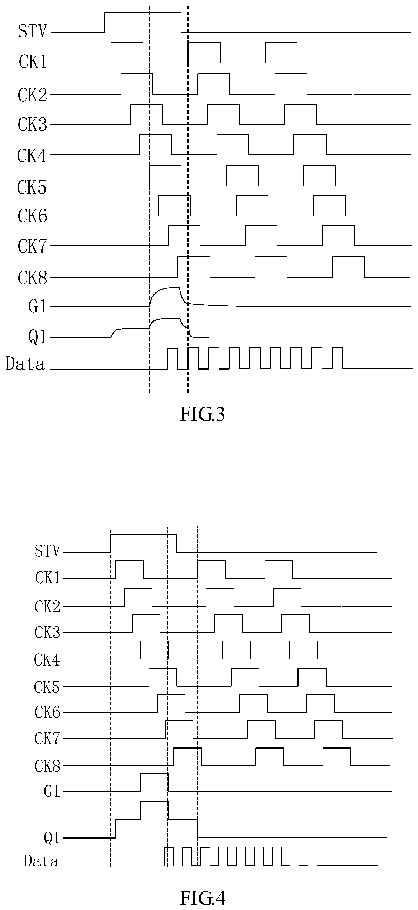

In the conventional art, a timing diagram of the eight groups of CK signals is shown as FIG. 3, wherein, CK1 and CK 5 are opposite, CK2 and CK6 are opposite, CK3 and CK7 are opposite, and CK4 and CK8 are opposite. A time interval that is an overlapped portion of adjacent CK signals is called H. the signal ST(N-4) is connected with previous four stage of stage transfer output signal ST(N-4). For example, when a previous stage is tenth stage, the first connection terminal of T3 receives a stage transfer signal ST(6) outputted by a sixth stage shift register unit.

Optionally, the first connection terminals of T3 of previous four stages (that is a first stage, a second stage, a third stage and a fourth stage) are connected with a signal STV. In the present embodiment, the signal STV is a start pulse trigger signal. Each frame has one pulse. A pulse width of the pulse is 8*H, an overlap between STV and CK1 is H.

Here, using the first stage as an example, the first control signal XCK of the first stage is CK1, the clock signal CK is CK5. In an actual application, in order to obtain a good falling waveform of G1, a waveform of the node Q1 is design as with a protrusion portion. The purpose is that when the voltage of Q1 is a voltage at a right shoulder of the protrusion portion, a low level of CK5 that control G1 can be written in such that the level of G1 can be pulled down to a low level quickly so that the voltage waveform of G1 can has a good falling waveform. However, in the conventional art, the right shoulder of the waveform of Q1 is very small (about 0.8H), the time is shorter so that for a larger RC delay of gate line of a high resolution display, such a short time cannot pull down the level of G1 quickly. As a result, a peak at the right shoulder of the waveform of G1 is existed. The peak at the right shoulder of the waveform of G1 will generate a wrong charging of the data signal so as to generate an abnormal display.

With reference to FIG. 4, in the present embodiment, when the first control signal XCK is at a first level, the pull-up control circuit is turned on, and outputs the second control signal Q(N) such that the first switching tube T1 of the pull-up circuit is conductive. After a falling edge of the clock signal CK, the first control signal is at the first level with a time interval that is greater than a preset value.

Optionally, in one period of the first control signal, a time interval that the first control signal is at the first level is greater than 50%.

In the present embodiment, for a N-th shift register unit, the first control signal is CK(N), the clock signal is CK(N+3), a time length of one period of the CK signal is 8H, a rising edge of a signal CK(N+1) is delayed with a time H comparing to a rising edge of the signal CK(N), wherein, N is a positive integer, H is an unit time length. Wherein, a stage transfer signal inputted at a stage transfer signal input terminal of each of the first shift register, the second shift register and the third shift register is a STV signal. A rising edge of a signal CK(1) is delayed with a time H comparing to a rising edge of the STV signal. When N is greater than 3, a stage transfer signal inputted at a stage transfer signal input terminal of a N-th shift register unit is a ST(N-3) signal that is outputted from a stage transfer signal output terminal of a (N-3)-th shift register unit.

Specifically, using a signal G(1) for illustrating the operation status of the circuit of the present invention.

Assuming that in this frame, LC1 is a high level H, and LC2 is a low level L.

When G(N)=G(1), a first connection terminal of T3 is connected with STV, a first connection terminal of T1 is inputted with CK4, control terminals of T3 and T4 is inputted with CK1.

When STV is at a high level, CK1 is at a high level, T3 and T4 are turned on, and the high level of STV is sent to Q(1). The point Q is at a high level. At the same time, T1 is turned on, and at this time, CK4 is at a low level so that G(1) is at a low level. At the same time, P(1) and Q(1) are at low levels, T6, T7, T8, T9, T10 and T11 are turned off, a low level of Vss will not affect the level of G(1).

Then, CK1 is at a low level, T3 and T4 are turned off. At this time, CK4 is at a high level and G(1) is at a high level. Q(1) is affected by a coupling effect of the capacitor C so that Q(1) is pulled up to a higher level. P(1) and K(1) keep at a low level.

Then, CK1 and CK4 are at a low level, however, Q(1) is affected by a coupling affect so that although the level of Q(1) is decreased, but the level of Q(1) is still at a high level. The low level of CK4 is sent to G(1), and G(1) is pulled down to a low level.

The time that the above G(1) is pulled down to the low level is 2.8H, and the time of 2.8H is long enough to let G(1) to be pulled down to the low level in order to effectively prevent slow falling time of Gate.

Then, CK1 is at a high level, the low level of STV is sent to Q(1), and Q(1) is pulled down to a low level, at the same time, K(1) is at a low level, P(1) is at a high level, T6, T7 and T8 are turned on. Q(1) and G(1) are further pulled down to a low level.

Through above way, through delaying a time that the CK signal is at a low level such that the gate signal can be completely pulled down to a low level so that a wrong charging generated by slow falling time of Gate is prevented.

It can be understood that the first connection terminals and the second connection terminals of the above switching tubes do not represent the order of pins of the switching tubes, and only represent a specific naming of the pins of the switching tubes. The switching tubes in the above embodiments are thin-film transistors (TFT) manufactured by IGZO. Optionally, in the above embodiment, the TFT is an N-type. The control terminal is a gate, the first connection terminal is a source, and the second connection terminal is a drain; or the connection terminal is a gate, the first connection terminal is a drain, and the second connection terminal is a source.

Besides, in another embodiment, a P-type TFT can be adopted to form the circuit connection. The only requirement is to adjust the level of the control terminal or the order of source and drain.

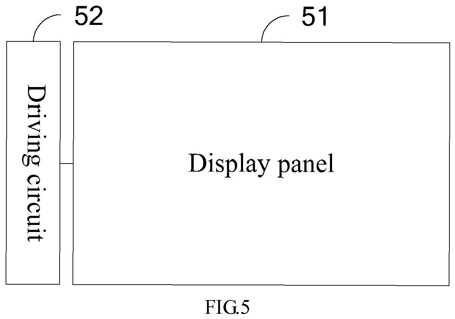

With reference to FIG. 5, FIG. 5 is a schematic structure diagram of a liquid crystal display device according to an embodiment of the present invention. The liquid crystal display device comprises a display panel 51 and a driving circuit 52. Wherein, the driving circuit 52 is disposed at a side of the display panel for driving the display panel.

Specifically, the driving circuit 52 can be the GOA circuit described above, the operation principle and circuit structure are similar, no more repeating.

The above embodiments of the present invention are not used to limit the claims of this invention. Any use of the content in the specification or in the drawings of the present invention which produces equivalent structures or equivalent processes, or directly or indirectly used in other related technical fields is still covered by the claims in the present invention.

## Claims

1. A GOA circuit including multiple cascade shift register units, and each shift register unit comprises:
a pull-up control circuit, a control terminal of the pull-up control circuit receives a first control signal, a first connection terminal of the pull-up control circuit receives a stage transfer signal, and a second connection terminal of the pull-up control circuit outputs a second control signal;
a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal;
a bootstrap capacitor coupled between the second connection terminal of the pull-up control circuit and the second connection terminal of the first switching tube; and
a transfer circuit including a second switching tube, wherein a control terminal of the second switching tube is coupled to the second connection terminal of the pull-up control circuit, a first connection terminal of the second switching tube receives the clock signal, and a second connection terminal of the second switching tube outputs a stage transfer signal;
wherein, when the first control signal is at a first level, the pull-up control circuit is turned on and outputs the second control signal such that the first switching tube of the pull-up circuit is turned on; and
wherein, after a falling edge of the clock signal, in one period of the first control signal, a time interval that the first control signal is at the first level is greater than 50%.

2. The GOA circuit according to claim 1, wherein,
for a N-th shift register unit, the first control signal is CK(N), the clock signal is CK(N+3), a time length of one period of the CK signal is 8H, a rising edge of a signal CK(N+1) is delayed with a time H comparing to a rising edge of the signal CK(N), wherein, N is a positive integer, H is an unit time length;
wherein, a stage transfer signal inputted at a stage transfer signal input terminal of each of the first shift register, the second shift register and the third shift register is a STV signal; a rising edge of a signal CK(1) is delayed with a time H comparing to a rising edge of the STV signal; when N is greater than 3, a stage transfer signal inputted at a stage transfer signal input terminal of a N-th shift register unit is a ST(N-3) signal that is outputted from a stage transfer signal output terminal of a (N-3)-th shift register unit.

3. The GOA circuit according to claim 1, wherein, the pull-up control circuit comprises:
a third switching tube;
a fourth switching tube, wherein, a first connection terminal of the fourth switching tube is coupled to a second connection terminal of the third switching tube, a second connection terminal of the fourth switching tube is coupled to the control terminal of the first switching tube; and
a fifth switching tube, wherein, a control terminal of the fifth switching tube is coupled to the control terminal of the first switching tube, a first connection terminal of the fifth switching tube is coupled to the first connection terminal of the fourth switching tube, a second connection terminal of the fifth switching tube is coupled to the second connection terminal of the first switching tube for controlling a level at the control terminal of the third switching tube to be less than a level at the first connection terminal of the third switching tube when the second connection terminal of the first switching tube output a high level.

4. The GOA circuit according to claim 3, wherein, the GOA circuit further comprises a first pull-down circuit and a clamp circuit;
wherein, the first pull-down circuit comprises:
a sixth switching tube, wherein a first connection terminal of the sixth switching tube is coupled to the second connection terminal of the first switching tube;
a seventh switching tube, wherein a first connection terminal of the seventh switching tube is coupled to the second connection terminal of the second switching tube; and
an eighth switching tube, wherein a first connection terminal of the eighth switching tube is coupled to the second connection terminal of the fourth switching tube;
wherein, the clamp circuit is coupled to control terminals and second connection terminals of the sixth switching tube, the seventh switching tube and the eighth switching tube for controlling a level of the control terminal of each of the sixth switching tube, the seventh switching tube and the eighth switching tube to be less than a level of the second connection terminal of each of the sixth switching tube, the seventh switching tube and the eighth switching tube when the second connection terminal of the first switching tube outputs the high level;
when the second connection terminal of the first switching tube outputs a low level, the clamp circuit controls the level of the control terminal of each of the sixth switching tube, the seventh switching tube and the eighth switching tube to be higher than the level of the second connection terminal of each of the sixth switching tube, the seventh switching tube and the eighth switching tube.

5. The GOA circuit according to claim 4, wherein, the GOA circuit further comprises a second pull-down circuit;
wherein, the second pull-down circuit comprises:
a ninth switching tube, wherein a first connection terminal of the ninth switching tube is coupled to the second connection terminal of the first switching tube;
a tenth switching tube, wherein a first connection terminal of the tenth switching tube is coupled to the second connection terminal of the second switching tube; and
an eleventh switching tube, wherein a first connection terminal of the eleventh switching tube is coupled to the second connection terminal of the fourth switching tube;
wherein, the clamp circuit is coupled to control terminals and second connection terminals of the ninth switching tube, the tenth switching tube and the eleventh switching tube for controlling a level of the control terminal of each of the ninth switching tube, the tenth switching tube and the eleventh switching tube to be less than a level of the second connection terminal of each of the ninth switching tube, the tenth switching tube and the eleventh switching tube when the second connection terminal of the first switching tube outputs the high level;
when the second connection terminal of the first switching tube outputs the low level, the clamp circuit controls the level of the control terminal of each of the ninth switching tube, the tenth switching tube and the eleventh switching tube to be higher than the level of the second connection terminal of each of the ninth switching tube, the tenth switching tube and the eleventh switching tube;
wherein, the clamp circuit controls the first pull-down circuit and the second pull-down circuit to operate alternately.

6. The GOA circuit according to claim 4, wherein, the clamp circuit includes a first control circuit, a second control circuit, a first clamp terminal, and a second clamp terminal;
the first clamp terminal is inputted with a first low level, coupled to the second connection terminals of the sixth switching tube, the seventh switching tube and the eighth switching tube; the second clamp terminal is inputted with a second low level, wherein, the first low level is higher than the second low level;
wherein, the first control circuit includes:
a twelfth switching tube, wherein a control terminal and a first connection terminal of the twelfth switching tube is inputted with a third control signal;
a thirteenth switching tube, wherein a control terminal of the thirteenth switching tube is coupled to a second connection terminal of the twelfth switching tube, a first connection terminal of the thirteenth switching tube is inputted with the third control signal, and a second connection terminal of the thirteenth switching tube is coupled to the control terminals of the sixth switching tube, the seventh switching tube and the eighth switching tube; and
a fifteenth switching tube, wherein a control terminal of the fifteenth switching tube is coupled to the second connection terminal of the fourth switching tube, a first connection terminal of the fifteenth switching tube is coupled to the second connection terminal of the thirteenth switching tube, and a second connection terminal of the fifteenth switching tube is coupled to the second clamp terminal.

7. The GOA circuit according to claim 6, wherein, the clamp circuit further comprises a second control circuit, and the second control circuit comprises:
a sixteenth switching tube, and a control terminal and a first connection terminal of the sixteenth switching tube is inputted with a fourth control signal;
a seventeenth switching tube, wherein a control terminal of the seventeenth switching tube is coupled to a second connection terminal of the sixteenth switching tube, a first connection terminal of the seventeenth switching tube is inputted with the fourth control signal, and a second connection terminal of the seventeenth switching tube is coupled to the control terminals of the ninth switching tube, the tenth switching tube and the eleventh switching tube;
an eighteenth switching tube, wherein a control terminal of the eighteenth switching tube is coupled to the second connection terminal of the fourth switching tube, a first connection terminal of the eighteenth switching tube is coupled to the second connection terminal of the sixth switching tube, and a second connection terminal of the eighteenth switching tube is coupled to the second clamp terminal; and
a nineteenth switching tube, wherein a control terminal of the nineteenth switching tube is coupled to the second connection terminal of the fourth switching tube, a first connection terminal of the nineteenth switching tube is coupled to the second connection terminal of the seventh switching tube, and a second connection terminal of the nineteenth switching tube is coupled to the second clamp terminal.

8. A GOA circuit including multiple cascade shift register units, and each shift register unit comprises:
a pull-up control circuit, a control terminal of the pull-up control circuit receives a first control signal, a first connection terminal of the pull-up control circuit receives a stage transfer signal, and a second connection terminal of the pull-up control circuit outputs a second control signal;
a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal; and
a bootstrap capacitor coupled between the second connection terminal of the pull-up control circuit and the second connection terminal of the first switching tube;
wherein, when the first control signal is at a first level, the pull-up control circuit is turned on and outputs the second control signal such that the first switching tube of the pull-up circuit is turned on; and
wherein, after a falling edge of the clock signal, a time interval that the first control signal is at the first level is greater than a preset value.

9. The GOA circuit according to claim 8, wherein, in one period of the first control signal, the time interval that the first control signal is at the first level is greater than 50%.

10. The GOA circuit according to claim 8, wherein,
the shift register unit further comprises a transfer circuit including a second switching tube, wherein a control terminal of the second switching tube is coupled to the second connection terminal of the pull-up control circuit, a first connection terminal of the second switching tube receives the clock signal, and a second connection terminal of the second switching tube outputs a stage transfer signal.

11. The GOA circuit according to claim 10, wherein,
for a N-th shift register unit, the first control signal is CK(N), the clock signal is CK(N+3), a time length of one period of the CK signal is 8H, a rising edge of a signal CK(N+1) is delayed with a time H comparing to a rising edge of the signal CK(N), wherein, N is a positive integer, H is an unit time length;
wherein, a stage transfer signal inputted at a stage transfer signal input terminal of each of the first shift register, the second shift register and the third shift register is a STV signal; a rising edge of a signal CK(1) is delayed with a time H comparing to a rising edge of the STV signal; when N is greater than 3, a stage transfer signal inputted at a stage transfer signal input terminal of a N-th shift register unit is a ST(N-3) signal that is outputted from a stage transfer signal output terminal of a (N-3)-th shift register unit.

12. The GOA circuit according to claim 10, wherein, the pull-up control circuit comprises:
a third switching tube;
a fourth switching tube, wherein, a first connection terminal of the fourth switching tube is coupled to a second connection terminal of the third switching tube, a second connection terminal of the fourth switching tube is coupled to the control terminal of the first switching tube; and
a fifth switching tube, wherein, a control terminal of the fifth switching tube is coupled to the control terminal of the first switching tube, a first connection terminal of the fifth switching tube is coupled to the first connection terminal of the fourth switching tube, a second connection terminal of the fifth switching tube is coupled to the second connection terminal of the first switching tube for controlling a level at the control terminal of the third switching tube to be less than a level at the first connection terminal of the third switching tube when the second connection terminal of the first switching tube output a high level.

13. The GOA circuit according to claim 12, wherein, the GOA circuit further comprises a first pull-down circuit and a clamp circuit;
wherein, the first pull-down circuit comprises:
a sixth switching tube, wherein a first connection terminal of the sixth switching tube is coupled to the second connection terminal of the first switching tube;
a seventh switching tube, wherein a first connection terminal of the seventh switching tube is coupled to the second connection terminal of the second switching tube; and
an eighth switching tube, wherein a first connection terminal of the eighth switching tube is coupled to the second connection terminal of the fourth switching tube;
wherein, the clamp circuit is coupled to control terminals and second connection terminals of the sixth switching tube, the seventh switching tube and the eighth switching tube for controlling a level of the control terminal of each of the sixth switching tube, the seventh switching tube and the eighth switching tube to be less than a level of the second connection terminal of each of the sixth switching tube, the seventh switching tube and the eighth switching tube when the second connection terminal of the first switching tube outputs the high level;
when the second connection terminal of the first switching tube outputs a low level, the clamp circuit controls the level of the control terminal of each of the sixth switching tube, the seventh switching tube and the eighth switching tube to be higher than the level of the second connection terminal of each of the sixth switching tube, the seventh switching tube and the eighth switching tube.

14. The GOA circuit according to claim 13, wherein, the GOA circuit further comprises a second pull-down circuit;
wherein, the second pull-down circuit comprises:
a ninth switching tube, wherein a first connection terminal of the ninth switching tube is coupled to the second connection terminal of the first switching tube;
a tenth switching tube, wherein a first connection terminal of the tenth switching tube is coupled to the second connection terminal of the second switching tube; and
an eleventh switching tube, wherein a first connection terminal of the eleventh switching tube is coupled to the second connection terminal of the fourth switching tube;
wherein, the clamp circuit is coupled to control terminals and second connection terminals of the ninth switching tube, the tenth switching tube and the eleventh switching tube for controlling a level of the control terminal of each of the ninth switching tube, the tenth switching tube and the eleventh switching tube to be less than a level of the second connection terminal of each of the ninth switching tube, the tenth switching tube and the eleventh switching tube when the second connection terminal of the first switching tube outputs the high level;
when the second connection terminal of the first switching tube outputs the low level, the clamp circuit controls the level of the control terminal of each of the ninth switching tube, the tenth switching tube and the eleventh switching tube to be higher than the level of the second connection terminal of each of the ninth switching tube, the tenth switching tube and the eleventh switching tube;
wherein, the clamp circuit controls the first pull-down circuit and the second pull-down circuit to operate alternately.

15. The GOA circuit according to claim 13, wherein, the clamp circuit includes a first control circuit, a second control circuit, a first clamp terminal, and a second clamp terminal;
the first clamp terminal is inputted with a first low level, coupled to the second connection terminals of the sixth switching tube, the seventh switching tube and the eighth switching tube; the second clamp terminal is inputted with a second low level, wherein, the first low level is higher than the second low level;
wherein, the first control circuit includes:
a twelfth switching tube, wherein a control terminal and a first connection terminal of the twelfth switching tube is inputted with a third control signal;
a thirteenth switching tube, wherein a control terminal of the thirteenth switching tube is coupled to a second connection terminal of the twelfth switching tube, a first connection terminal of the thirteenth switching tube is inputted with the third control signal, and a second connection terminal of the thirteenth switching tube is coupled to the control terminals of the sixth switching tube, the seventh switching tube and the eighth switching tube; and
a fifteenth switching tube, wherein a control terminal of the fifteenth switching tube is coupled to the second connection terminal of the fourth switching tube, a first connection terminal of the fifteenth switching tube is coupled to the second connection terminal of the thirteenth switching tube, and a second connection terminal of the fifteenth switching tube is coupled to the second clamp terminal.

16. The GOA circuit according to claim 15, wherein, the clamp circuit further comprises a second control circuit, and the second control circuit comprises:
a sixteenth switching tube, and a control terminal and a first connection terminal of the sixteenth switching tube is inputted with a fourth control signal;
a seventeenth switching tube, wherein a control terminal of the seventeenth switching tube is coupled to a second connection terminal of the sixteenth switching tube, a first connection terminal of the seventeenth switching tube is inputted with the fourth control signal, and a second connection terminal of the seventeenth switching tube is coupled to the control terminals of the ninth switching tube, the tenth switching tube and the eleventh switching tube;
an eighteenth switching tube, wherein a control terminal of the eighteenth switching tube is coupled to the second connection terminal of the fourth switching tube, a first connection terminal of the eighteenth switching tube is coupled to the second connection terminal of the sixth switching tube, and a second connection terminal of the eighteenth switching tube is coupled to the second clamp terminal; and
a nineteenth switching tube, wherein a control terminal of the nineteenth switching tube is coupled to the second connection terminal of the fourth switching tube, a first connection terminal of the nineteenth switching tube is coupled to the second connection terminal of the seventh switching tube, and a second connection terminal of the nineteenth switching tube is coupled to the second clamp terminal.

17. A liquid crystal display device including a GOA circuit, wherein the GOA circuit includes multiple cascade shift register units, and each shift register unit comprises:
a pull-up control circuit, a control terminal of the pull-up control circuit receives a first control signal, a first connection terminal of the pull-up control circuit receives a stage transfer signal, and a second connection terminal of the pull-up control circuit outputs a second control signal;
a pull-up circuit includes a first switching tube, and a control terminal of the first switching tube is coupled to the second connection terminal of the pull-up control circuit, a first connection terminal of the first switching tube receives a clock signal, and a second connection terminal of the first switching tube outputs a driving signal;
a bootstrap capacitor coupled between the second connection terminal of the pull-up control circuit and the second connection terminal of the first switching tube;
wherein, when the first control signal is at a first level, the pull-up control circuit is turned on and outputs the second control signal such that the first switching tube of the pull-up circuit is turned on; and
wherein, after a falling edge of the clock signal, a time interval that the first control signal is at the first level is greater than a preset value.

18. The liquid crystal display device according to claim 17, wherein, in one period of the first control signal, the time interval that the first control signal is at the first level is greater than 50%.

19. The liquid crystal display device according to claim 17, wherein,
the shift register unit further comprises a transfer circuit including a second switching tube, wherein a control terminal of the second switching tube is coupled to the second connection terminal of the pull-up control circuit, a first connection terminal of the second switching tube receives the clock signal, and a second connection terminal of the second switching tube outputs a stage transfer signal.
